(19) Europäisches Patentamt
European Patent Office
Office européen des brevets

(11) **EP 3 866 250 B1**

(12) **EUROPÄISCHE PATENTSCHRIFT**

(45) Veröffentlichungstag und Bekanntmachung des Hinweises auf die Patenterteilung:
**13.09.2023 Patentblatt 2023/37**

(21) Anmeldenummer: **21150009.5**

(22) Anmeldetag: **04.01.2021**

(51) Internationale Patentklassifikation (IPC):
**H01M 10/48** (2006.01)    **G01R 31/392** (2019.01)

(52) Gemeinsame Patentklassifikation (CPC):
**H01M 10/482; G01R 31/392;** H01M 2200/00; H01M 2220/20; Y02E 60/10

(54) **VERFAHREN ZUR KATEGORISIERUNG EINER BATTERIE HINSICHTLICH IHRER WEITEREN HANDHABUNGSEIGNUNG UND BATTERIEVERWERTUNGSSYSTEM**

METHOD FOR CATEGORIZING A BATTERY WITH RESPECT ITS SUITABILITY FOR FURTHER HANDLING AND BATTERY RECOVERY SYSTEM

PROCÉDÉ DE CATÉGORISATION D'UNE BATTERIE EN CE QUI CONCERNE SA APTITUDE À LA MANIPULATION ULTÉRIEURE ET SYSTÈME DE VALORISATION DE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.02.2020 DE 102020201697**

(43) Veröffentlichungstag der Anmeldung:
**18.08.2021 Patentblatt 2021/33**

(73) Patentinhaber: **VOLKSWAGEN AG**
**38440 Wolfsburg (DE)**

(72) Erfinder:
• **Börger, Dr. Alexander**
**38165 Flechtorf (DE)**
• **Mertens, Jan**
**38118 Braunschweig (DE)**

(56) Entgegenhaltungen:
**DE-A1-102016 211 898    DE-A1-102016 220 860**
**US-A1- 2016 018 345**

**Beschreibung**

Die Erfindung betrifft ein Verfahren zur Kategorisierung einer Batterie hinsichtlich ihrer weiteren Handhabungseignung. Des Weiteren offenbart ist eine Batterie, insbesondere eine solche für ein Kraftfahrzeug. Außerdem offenbart ist auch ein Kraftfahrzeug mit einer solchen Batterie. Ferner betrifft die Erfindung ein Batterieverwertungssystem.

Die voranschreitende Elektrifizierung von Kraftfahrzeugen erfordert insbesondere aufgrund seitens Kunden gewünschter vergleichsweise hoher Reichweiten den Einsatz von großen - insbesondere im Sinne ihrer (Speicher-) Kapazität - Batterien. Diese sind üblicherweise durch eine Vielzahl von zu Batteriemodulen zusammengefassten Batteriezellen (üblicherweise sogenannte Sekundärzellen) gebildet. Meist handelt es sich dabei um Lithium-Ionen-Zellen, die derzeit aufgrund ihrer Energiedichte vorteilhaft sind.

Die - auch als "Traktionsbatterien" bezeichneten - Batterien sind einerseits hinsichtlich einer erreichbaren Reichweite und andererseits für eine als zweckmäßig erachtete Lebensdauer - häufig bemessen an einer möglichen Ladezykluszahl - ausgelegt. Nach Erreichen ihrer Lebensdauer können die Batterien optional einer Zweitverwendung zugeführt werden - bspw. als Zwischenspeicher in Ladestationen oder dergleichen - oder einer Weiterverwertung mittels Recycling der Materialien. Insbesondere um auch einen Schaden an der Batterie, bspw. an einzelnen Zellen zu vermeiden, oder zur Frage, ob die Batterie einer Zweitverwendung oder Weiterverwertung zuzuführen ist, ist es also zweckmäßig, die Batterie dahingehend zu überwachen und zu beurteilen.

Aus CN 106324516 A ist bspw. ein Recyclingmodus bekannt, in welchem ein Batteriemanagementsystem der Batterie erkennt, ob die Batterie recycelt werden soll. Der ermittelte Batteriezustand und Informationen zur Batterie werden dabei an eine Recyclingstelle automatisch übermittelt.

Aus DE 10 2015 110 961 A1 ist eine Batterieinspektionshilfe bekannt, die ein Etikett enthält mit einem temperaturempfindlichen Abschnitt, der Temperaturänderungen anzeigt, und einem belastungsempfindlichen Abschnitt, der Positionsänderungen anzeigt. Beim Inspizieren der Batterie können anhand des temperaturempfindlichen Abschnitts des Etiketts Änderungen bei einer Temperatur der Batterie und anhand des belastungsempfindlichen Abschnitts des Etiketts Änderungen bei einer Belastung der Batterie erkannt werden.

Aus DE 10 2016 220 860 A1, US 2016 0018 345 A1 und DE 10 2016 211 898 A1 sind jeweils Verfahren bekannt, die dazu dienen eine Batterie hinsichtlich ihres Zustands zu überwachen.

Der Erfindung liegt die Aufgabe zugrunde, die Kategorisierung einer Batterie hinsichtlich ihrer weiteren Handhabungseignung zu verbessern.

Diese Aufgabe wird erfindungsgemäß gelöst durch die Merkmale des Anspruchs 1. Außerdem wird diese Aufgabe erfindungsgemäß gelöst durch ein Batterieverwertungssystem mit den Merkmalen des Anspruchs 5. Vorteilhafte und teils für sich erfinderische Ausführungsformen und Weiterentwicklungen der Erfindung sind in den Unteransprüchen und der nachfolgenden Beschreibung dargelegt.

Das erfindungsgemäße Verfahren dient zur Kategorisierung einer Batterie, insbesondere einer Traktionsbatterie eines Kraftfahrzeugs, hinsichtlich ihrer weiteren Handhabungseignung. Vorzugsweise weist die Batterie wenigstens eine Batteriezelle (insbesondere eine Sekundärzelle, also eine wiederaufladbare Zelle) auf, bevorzugt mehrere solcher Batteriezellen.

Verfahrensgemäß wird im Betrieb der Batterie eine Vielzahl von sicherheitsrelevanten und lebensdauerrelevanten Betriebsgrößen für wenigstens eine Batteriezelle der Batterie erfasst. Mittels einer zweistufigen Auswertung wenigstens einer der Betriebsgrößen und/oder einer daraus abgeleiteten Rechengröße wird dann eine Kategorisierungsgröße bestimmt. Hierzu wird in einer ersten Stufe für wenigstens eine sicherheitsrelevante Betriebsgröße eine Sicherheitsgröße abgeleitet und mit einem zugeordneten Schwellwert verglichen. Für den Fall, dass der Schwellwert oder wenigstens einer der gegebenenfalls mehreren Schwellwerte (durch die Sicherheitsgröße) unterschritten wird, wird in einer zweiten Stufe mittels einer Mehrzahl der lebensdauerrelevanten Betriebsgrößen eine Ausfallprognose erstellt. Die Kategorisierungsgröße wird dann anhand der Ausfallprognose bestimmt.

Vorzugsweise wird für den Fall, dass der Schwellwert oder insbesondere einer der gegebenenfalls mehreren Schwellwerte überschritten wird, für die Batterie eine Recycling-Kategorie vergeben, d. h. insbesondere eine Recycling-Empfehlung - d. h. eine Empfehlung einer Materialverwertung der Batterie - ausgegeben.

Die anhand der lebensdauerrelevanten Betriebsgrößen erstellte Ausfallprognose wird auch als "Performance"- oder "Durability"-Größe, d. h. "Leistungsfähigkeits"- oder "Haltbarkeitsgröße", bezeichnet.

Dadurch, dass ein zweistufiger Prozess zur Kategorisierung herangezogen wird, in dem Sicherheitsaspekte einerseits und Lebensdaueraspekte andererseits betrachtet werden, kann auf einfache Weise eine hohe oder zweckmäßige "Auflösung" bei der Betrachtung der weiteren Handhabungsmöglichkeiten ermöglicht werden. Denn sofern Sicherheitskriterien nicht erfüllt werden, wird dies erkanntermaßen gegenüber Lebensdaueraspekten priorisiert. Eine gemeinsame Betrachtung oder Vermengung sicherheits- und lebensdauerrelevanter Aspekte, die zu Ungenauigkeiten bei der Auswertung führen können, erfolgt mithin nicht. Somit wird eine vergleichsweise hohe Aussagekraft der Kategorisierung ermöglicht.

Die Begriffe "Schwellwert- oder Grenzwert-Unterschreitung" sind hier und im Folgenden so zu verstehen, dass die Differenz der Sicherheitsgröße (oder auch der Kategorisierungsgröße) und des Schwell- oder Grenzwertes das Vorzeichen nicht wechselt. Im Gegensatz dazu ist eine "Überschreitung" stets richtungsunabhängig in dem Sinne zu verstehen, dass diese Differenz ihr Vorzeichen wechselt.

Vorzugsweise wird das hier und im Folgenden beschriebene Verfahren von einem Batteriemanagementsystem der Batterie, einer von dem Hersteller der Batterie oder eines die Batterie aufweisenden Systems, vorzugsweise eins Kraftfahrzeugs, bereitgestellten Datenbank und/oder einer der Fertigung nachgelagerten Dienstleistungsstelle (bspw. einer Werkstatt, einem Recyclingunternehmen oder dergleichen) durchgeführt.

Die Konjunktion "und/oder" ist hier und im Folgenden insbesondere derart zu verstehen, dass die mittels dieser Konjunktion verknüpften Merkmale sowohl gemeinsam als auch als Alternativen zueinander ausgebildet sein können.

In der ersten Stufe wird für wenigstens eine Batteriezelle der Batterie (als Sicherheitsgröße) eine sogenannte Historiengröße anhand der wenigstens einen für diese Batteriezelle ermittelten sicherheitsrelevanten Betriebsgröße, nämlich anhand der Temperatur, der Spannung (oder damit verknüpften elektrischen Größen), eines Drucks und/oder der Gaskonzentration eines Zersetzungsgases, ermittelt. Diese Historiengröße spiegelt bevorzugt eine vorhergehende (d. h. in der Vergangenheit liegende) Betriebsbelastung der oder der jeweiligen Batteriezelle wieder. Beispielsweise geht in diese Historiengröße insbesondere der Verlauf der jeweiligen Betriebsgröße über einen Zeitraum zwischen einer vorhergehenden und der aktuellen Kategorisierung ein.

In einer bevorzugten Verfahrensvariante wird als Sicherheitsgröße, insbesondere als die vorstehend genannte Historiengröße die (sogenannte) Shannon-Entropie anhand der wenigstens einen für diese Batteriezelle ermittelten sicherheitsrelevanten Betriebsgröße, insbesondere anhand der Temperatur (insbesondere der "Zelltemperatur"), der Spannung, eines Drucks (insbesondere des Zellinnendrucks) und/oder der Gaskonzentration eines Zersetzungsgases ermittelt. Vorzugsweise wird hierzu für jede Batteriezelle und jede sicherheitsrelevante Betriebsgröße ein Datensatz - der vorzugsweise den Verlauf der jeweiligen Betriebsgröße über den Zeitraum zwischen der vorhergehenden und der aktuellen Kategorisierung wiedergibt - gebildet. Ferner werden jeder verwendeten Betriebsgröße mehrere Wertebereiche zugeordnet und die Einzelwerte der jeweiligen Betriebsgröße in diese Wertebereiche sortiert. Beispielsweise werden für die Temperatur vier Bereiche vorgegeben, insbesondere "Bereich A" von einem Minimalwert (bspw. der geringste erfasste Wert oder ein herstellerspezifisch vorgegebener Wert) bis 10 Grad Celsius, "Bereich B" von 10 bis 20 Grad Celsius, "Bereich C" von 20 bis 30 Grad Celsius und "Bereich D" von 30 Grad Celsius bis zu einem Maximalwert. Die Anzahl der Wertebereiche ist hierbei vorzugsweise herstellerspezifisch vorgegeben. Jedem Wertebereich wird anschließend bevorzugt eine Auftritts-Wahrscheinlichkeit zugeordnet, insbesondere indem die Zahl der Einzelwerte im jeweiligen Wertebereich durch die Gesamtzahl aller Einzelwert des jeweiligen Datensatzes geteilt wird. Die Shannon-Entropie der jeweiligen Betriebsgröße (insbesondere der betrachteten physikalischen Größe) ergibt sich dann zu

$$E_i = -\sum_{j=1}^{n}\{p_j * \log_a(p_j)\} \tag{1}$$

dabei ist

- i: Nummer des betrachteten Datensatzes
- j: Nummer des betrachteten Wertebereichs
- n: Anzahl der definierten Wertebereiche
- $p_j$: Auftritts-Wahrscheinlichkeit des j-ten Wertebereichs des i-ten Datensatzes
- a: Basis des Logarithmus (insbesondere wird die Basis 10, die Basis 2 oder die Basis e herangezogen).

Optional kann zusätzlich oder alternativ zu der vorstehend beschriebenen Shannon-Entropie als Sicherheitsgröße, insbesondere als Historiengröße, auch wenigstens eine der Rechengrößen "State of Health" oder "State of Power" in die vorstehend beschriebene Sicherheitsbetrachtung mit einfließen. Die Rechengröße State of Health wird hierbei vorzugsweise anhand einer der Betriebsgrößen oder einer gewichtete Kombination wenigstens zweier der Betriebsgrößen interner Widerstand, interne Impedanz, interne Leitfähigkeit, Kapazität, Spannung, Selbstentladerate, Anzahl der Zyklen, Betriebsdauer der Batterie, Temperatur der Batteriezelle, Ladungsaufnahme, Gesamtladungsdurchsatz, Gesamtleistungsdurchsatz und Gesamtenergiedurchsatz gebildet.

Für den Gesamtladungsdurchsatz wird nachfolgend beispielhaft die Ermittlung eines State of Health beschrieben. Dieses Vorgehen kann jedoch auch auf die anderen genannten Betriebsgrößen angewendet werden. Mehrere Betriebsgrößen können dabei außerdem mittels einer Gewichtungsfunktion in der Berechnung des State of Health berücksichtigt werden. Für einen konstanten Strom I über die Zeit t gilt für den Ladungsdurchsatz Q:

$$Q = I * t \tag{2}$$

Da der Strom nicht konstant über die Zeit ist, muss der zeitveränderliche Strom i(t) über die Zeit (insbesondere über den Zeitraum zwischen vorhergehender und aktueller Kategorisierung) integriert werden. Um einen Gesamtladungsdurchsatz zu ermitteln, müssen außerdem sowohl Lade- als auch Entladeströme berücksichtigt werden, weshalb der Betrag der zeitveränderlichen Ströme herangezogen wird:

$$Q = \int_{t1}^{t2}\{|i(t)|\}\,dt \qquad (3)$$

Durch Diskretisierung in m Abschnitte ergibt sich:

$$Q = \sum_{k=1}^{m}\{|I_k| * t_i\} \qquad (4)$$

Da hohe Ströme den State of Health stärker als niedrige Ströme beeinflussen, wird der diskretisierte Gesamtladungsdurchsatz über einen Exponenten n stromgewichtet. Dieser Exponent wird empirisch für eine Batteriezelle ermittelt. Weiterhin wird durch den gemittelten Strombetrag dividiert, um die Einheit des Ladungsdurchsatzes zu erhalten:

$$Q_{gew} = \sum_{k-1}^{m}\{I * t_k / I_{mittel}^{n-1}\} \qquad (5)$$

Hierbei berechnet sich der gemittelte Strombetrag zu:

$$I_{mittel} = \sum_{k=1}^{m}\left\{|I_k| * \frac{t_k}{t_{gesamt}}\right\} \qquad (6)$$

Der State of Health ("SoH") ergibt sich aus nun aus der Formel:

$$SoH = (Q_{char} - Q_{gew}) * 100/Q_{char} \qquad (7)$$

wobei $Q_{char}$ den charakteristischen Gesamtladungsdurchsatz der Batterie darstellt.

Außerdem beeinflussen hohe Temperaturen den State of Health stärker als niedrige Temperaturen. Deshalb wird aus der Arrheniusgleichung vereinfacht abgeleitet, dass sich die Reaktionsgeschwindigkeit (und somit auch die Alterung) bei einer Temperaturerhöhung um 10 K verdoppelt ("RGT-Regel"). Deshalb wird der gewichtete Ladungsdurchsatz in der Formel für den State of Health um den Einfluss der Temperatur nach der RGT -Regel und einer festgelegten Bezugstemperatur $T_{nenn}$ gewichtet. Hierbei stellt $T_{nenn}$ diejenige Bezugstemperatur dar, bei der die Alterung mit dem Faktor 1 verläuft:

$$SoH = (Q_{char} - (2 * (T/10 - T_{nenn}/10) + 1) * Q_{gew}) * 100/Q_{char} \qquad (8)$$

In einer beispielshaften Verfahrensvariante wird der Gesamtenergiedurchsatz aus einer Kombination der Energiedichte der Batteriezelle sowie der Zyklenzahl bestimmt:

$$E_{ges} = w_{zelle} * m_{zelle} * n \qquad (9)$$

$$E_{ges} = w_{zelle} * V_{zelle} * n \qquad (10)$$

wobei $E_{ges}$ der Gesamtenergiedurchsatz, $w_{zelle}$ die gravimetrische bzw. volumetrische Energiedichte der Zelle, $m_{zelle}$ das Gewicht der Zelle, $V_{zelle}$ das Volumen der Zelle und n die Zyklenzahl (n kann auch reelle Werte annehmen) darstellen.

Insbesondere wird also anhand der Historiengröße ermittelt, ob aufgrund während des vorausgehenden Betriebs der oder der jeweiligen Batteriezelle aufgetreten unzulässigen Betriebszuständen, etwas gegen eine, insbesondere für eine Verwendung im Kraftfahrzeug, sichere Weiternutzung der entsprechenden Batteriezelle spricht.

In der zweiten Stufe wird für wenigstens eine Batteriezelle der Batterie mittels der lebensdauerrelevanten Betriebsgrößen die Ausfallprognose anhand eines statistischen Modells ermittelt. In dieses Modell werden dabei die Betriebsgrößen Betriebsdauer der Batteriezelle, Zyklenzahl der Batteriezelle, Kapazität der Batteriezelle, schnellgeladene Gesamtleistungsmenge und/oder Kilometerstand des die Batterie umfassenden Kraftfahrzeugs einbezogen.

In einer bevorzugten Variante wird in der zweiten Stufe für wenigstens eine Batteriezelle der Batterie mittels der lebensdauerrelevanten Betriebsgrößen die Ausfallprognose konkret anhand einer Weibullverteilung ermittelt. In diese Weibullverteilung werden insbesondere die Betriebsgrößen (konkret vorzugsweise deren aktuell ermittelten Werte) Betriebsdauer der Batteriezelle, Zyklenzahl der Batteriezelle, Kapazität der Batteriezelle, schnellgeladene Gesamtleistungsmenge und/oder Kilometerstand des die Batterie umfassenden Kraftfahrzeugs einbezogen (sowie insbesondere mit entsprechenden charakteristischen oder typischen Werten für die Grö-ßen in Relation gesetzt). Diese adaptierte Weibullverteilung beschreibt die Wahrscheinlichkeit eines Ausfalls einer Batteriezelle in Prozent.

Bevorzugt wird die (insbesondere zweiparametrige) Weibullverteilung anhand der Formel:

$$F(t, n, p, c) = 1 - e^{\left(\alpha * \left(\frac{[t-t0]}{[T-t0]}\right) + \beta * \left(\frac{[n-n0]}{[N-n0]}\right) + \gamma * \left(\frac{[p-p0]}{[P-p0]}\right) + \kappa * \left(\frac{[c-c0]}{[C-c0]}\right) + \nu * \left(\frac{[r-r0]}{[R-r0]}\right)\right)^{b}} \tag{11}$$

Bestimmt. Hierbei sind:

- t: gemessene (d. h. insbesondere aktuell aufgelaufene) Betriebsdauer der Batteriezelle, vorzugsweise seit der letzten Kategorisierung,
- t0: anfängliche Betriebsdauer der Batteriezelle zu Beginn der Betrachtungen, d. h. insbesondere zum Zeitpunkt der letzten Kategorisierung,
- T: charakteristische Betriebsdauer der Batteriezelle (vom Hersteller im Rahmen der Auslegung vorgegeben z.B. T = 5000 h für Elektrofahrzeuge),
- n: gemessene (insbesondere aufgelaufene) Zyklenzahl der Batteriezelle,
- n0: anfängliche Zyklenzahl der Batteriezelle zu Beginn der Betrachtungen,
- N: charakteristische Zyklenzahl der Batteriezelle (vom Hersteller im Rahmen der Auslegung vorgegeben z.B. N = 1000 für typische Lithium-Ionen Batterien),
- c: gemessene Kapazität der Batteriezelle,
- c0: anfängliche Kapazität der Batteriezelle zu Beginn der Betrachtungen,
- C: charakteristische Kapazität der Batteriezelle (vom Hersteller im Rahmen der Auslegung vorgegeben z.B. C = 4500 mAh für typische Lithium-Ionen-Batterien),
- p: schnell geladene Gesamtleistungsmenge über die betrachtete Betriebsdauer,
- p0: anfänglich schnellgeladene Gesamtleistungsmenge zu Beginn der Betrachtungen,
- P: charakteristische schnellgeladene Gesamtleistungsmenge (vom Hersteller im Rahmen der Auslegung vorgegeben),
- r: gemessener (insbesondere aufgelaufener) Kilometerstand des Kraftfahrzeugs,
- r0: Kilometerstand des Elektrofahrzeugs zum Einbau der Batteriezelle,
- R: charakteristischer Kilometerstand eines Elektrofahrzeugs (vom Hersteller im Rahmen der Auslegung vorgegeben),
- a, β, γ, κ, ν: festgelegte Gewichtungsfaktoren für die verschiedenen Auslegungsparameter,
- b: Formfaktor der Weibullverteilung (Für die Betrachtung von Frühausfällen wird ein Formparameter b < 1 gewählt. Für die Betrachtung von Zufallsausfällen wird ein Formparameter b = 1 gewählt, was insbesondere für eine konstant angenommene Ausfallrate steht. Für Verschleiß- und Ermüdungsausfälle wird ein Formparameter b > 1 gewählt.).

Die Gesamtleistungsmenge p wird in vorstehender Variante vorzugsweise anhand von

$$p = \int_{t1}^{t2} \{|i(t)| * u(t)\} \, dt \tag{12}$$

Insbesondere analog zur Gesamtladungsmenge ermittelt, wobei u(t) die zeitveränderliche Spannung beschreibt.

Dadurch dass in der ersten und insbesondere der zweiten Stufe statistische Methoden zur Kategorisierung eingesetzt werden, sind die dadurch treffbaren Aussagen vorteilhafterweise vergleichsweise zuverlässig.

Die, insbesondere anhand der vorstehend beschriebenen Weibullverteilung, ermittelte Ausfallprognose der oder der jeweiligen Batteriezelle wird anhand ihres Zahlenwerts einem Wertebereich der Kategorisierungsgröße zugeordnet.

Der Kategorisierungsgröße werden dabei wenigstens die Wertebereiche "Neuwertig" (bspw. für eine Ausfallprognose von 0 bis 5 Prozent; eine Verwendung im Kraftfahrzeug ist ohne Weiteres möglich), "Fahrzeugverwendung" (bspw. für eine Ausfallprognose von 5 bis 35 Prozent; zeigt an, dass die Batterie gebraucht ist, aber weiter für ein Kraftfahrzeug zu verwenden ist), "Zweitnutzung" (oder auch "industrial grade"; bspw. für eine Ausfallprognose von 35 bis 60 Prozent; zeigt an, dass eine dem Hauptverwendungszweck nachgeordnete Verwendung zu empfehlen ist) und "Recycling" (auch: "recycling grade"; bspw. für eine Ausfallprognose von 60 bis 100 Prozent; zeigt an, dass die Batterie der Materialverwertung zugeführt werden sollte) zugeordnet werden. Diese Wertebereiche oder "Kategorien" geben mithin die Handhabungseignung der Batterie an. Dabei werden dem Nutzer der Batterie auch entsprechende Empfehlungen oder Hinweise zur weiteren Handhabung angegeben, bspw. "uneingeschränkte Verwendung der Batterie im Fahrzeug möglich", "Austausch der Batterie empfohlen, Nachfolgeverwendung der Batterie möglich" oder "Austausch der Batterie und Zuführung zum Recycling empfohlen".

In einer zu der vorstehend beschriebenen Anwendung der Weibullverteilung alternativen Variante wird die Ausfallprognose erstellt, indem zunächst für Batteriezellen einer Produktionseinheit (auch: "Los", "Lot" oder "Charge") Fehlerdichtefunktionen statistisch anhand von Tests bestimmt werden. Diese Fehlerdichtefunktionen werden zumindest abschnittsweise mittels einer Weibullverteilung "erklärt", d. h. insbesondere abgebildet, so dass (insbesondere abschnittsweise) Fehlerraten für Batteriezellen abgeleitet werden können, die je nach Art des Ausfalls (Frühausfall, Zufallsausfall, Alterungsausfall) zeitlich veränderlich oder insbesondere bei Zufallsausfällen zeitlich konstant sind. Optional werden diese derart ermittelten Fehlerraten anschließend entweder (insbesondere gewichtet) kombiniert oder einzeln als Parameter in ein Beschreibungsmodell für die Batteriezellen (optional für das aus diesen gebildete Batteriemodul und/oder für die wiederum dieses umfassende Traktionsbatterie) eingesetzt. Als Beschreibungsmodelle kommen beispielsweise Zuverlässigkeitsgraphen, Markov-Ketten oder dergleichen zum Einsatz. Aus dem derart parametrierten Beschreibungsmodell wird anschließend wenigstens ein Kennwert für die Zuverlässigkeit und/oder für die Ausfallwahrscheinlichkeit der jeweiligen Batteriezelle (bzw. des Batteriemoduls bzw. der Traktionsbatterie) abgeleitet. Dieser Kennwert bzw. diese Kennwerte stellen dabei insbesondere die vorstehend beschriebene Ausfallprognose dar. Insbesondere werden dem Beschreibungsmodell ebenfalls die vorstehend genannten (bevorzugt die aktuell erfassten Werte der) lebensdauerrelevanten Betriebsgrößen, vorzugsweise Betriebsdauer der Batteriezelle, Zyklenzahl der Batteriezelle, Kapazität der Batteriezelle, schnellgeladene Gesamtleistungsmenge und/oder Kilometerstand des die Batterie umfassenden Kraftfahrzeugs als Eingangsgrößen zugeführt. Wie bereits vorstehend beschrieben wird auch hierbei die ermittelte Ausfallprognose der oder der jeweiligen Batteriezelle anhand ihres Zahlenwerts dem entsprechenden Wertebereich der Kategorisierungsgröße zugeordnet.

Optional erfolgt - bspw. nach Freigabe durch den Nutzer oder Servicepersonal - insbesondere mittels einer entsprechenden im Batteriemanagementsystem und/oder der Datenbank hinterlegten Maßnahmen eine Vorbereitung der Batterie auf die Nachfolgeverwendung oder das Recycling. Diese Vorbereitung umfasst bspw. ein Entladen der Batterie auf einen jeweils vorgegebenen "Restwert", eine Temperierung auf einen vorgegebenen Temperaturwert und/oder dergleichen. Insbesondere ist das Batteriemanagementsystem auch dazu eingerichtet, vor Einleitung derartiger Schritte (Hochvolt-) Schütze zwischen der Batterie und Verbrauchern, im Kraftfahrzeug insbesondere das "Bordnetz", bspw. nachgeordnete Steuerungen und wenigstens ein Elektromotor, zu öffnen.

In einer zweckmäßigen, zusätzlichen Verfahrensvariante wird zumindest einer Batteriezelle anhand von im Betrieb der Batterie erfasster Sonderereignisse, die ein Recycling unmöglich machen, die Sonderkategorie "Sondermüll" zugeordnet. Bspw. ist dies der Fall, wenn für die entsprechende Batteriezelle eine vollständige thermische Schädigung, eine einen Grenzwert überschreitende mechanische Schädigung (somit also eine "ernsthafte" Schädigung) oder dergleichen festgestellt wurde.

Vorzugsweise erfolgt die hier und im Folgenden beschriebene Kategorisierung der Batterie (bzw. der jeweiligen Batteriezelle) in vorgegebenen Intervallen und/oder zu individuell auswählbaren Zeitpunkten. In letzterem Fall kann beispielsweise die Kategorisierung im Rahmen eines Fahrzeugservices vom Servicepersonal ausgelöst werden.

In einer weiter bevorzugten Verfahrensvariante, die insbesondere für den Fall angewendet wird, dass die Batterie wie vorstehend beschriebenen mehrere in wenigstens ein Batteriemodul zusammengefasste Batteriezellen (vorzugsweise auch mehrere Batteriemodule) umfasst, wird die Kategorisierungsgröße für zumindest mehrere, vorzugsweise für alle dieser Batteriezellen ermittelt. Anhand der einzelnen Kategorisierungsgrößen für die Batteriezellen werden anschließend vorzugsweise eine Modul- und eine Batterie-Kategorisierungsgröße ermittelt.

Vorzugsweise wird wie vorstehend anhand Formel (1) für jede oder zumindest einen Teil der Batteriezellen die "individuelle" Shannon-Entropie ermittelt. Anschließend wird daraus der arithmetische Mittelwert abgeleitet:

$$E = \sum_{i=1}^{m} \{E_i / m\} \qquad (13)$$

Hierbei sind:

- i: Nummer der betrachteten Shannon-Entropie
- $E_i$: Die Shannon Entropie des i-ten Datensatzes einer betrachteten physikalischen Größe
- m: Anzahl aller Datenätze.

Hieraus wird insbesondere die Standardabweichung aller Shannon-Entropien der (insbesondere für einen Betrachtungszeitraum erfassten) Datensätze bestimmt:

$$\sigma_E = \sqrt{\left(\frac{1}{m} - \sum_{i=1}^{m}\{E_i - E\}^2\right)} \qquad (14)$$

Hieraus wird anschließend vorzugsweise ein sogenannter Abnormalitätskoeffizient $A_i$ jedes einzelnen Datensatzes abgeleitet:

$$A_i = |E_i - E|/\sigma_E \qquad (15)$$

Der Abnormalitätskoeffizient stellt insbesondere ein Maß dafür dar, um wie viele Standardabweichungen eine Shannon-Entropie von dem Mittelwert aller Shannon-Entropien abweicht. Dieser Abnormalitätskoeffizient sowie optional zusätzlich oder alternativ die Standardabweichung wird bzw. werden vorteilhafterweise genutzt, um statistische Ausreißer in den Messdaten einer betrachteten physikalischen Größe mit vergleichsweise geringem Aufwand zu ermitteln und vorzugsweise auch aus der vorstehend beschriebenen Betrachtung auszuschließen.

Vorzugsweise wird aus den einzelnen Kategorisierungsgrößen der Batteriezellen eine prozentuale Verteilung der einzelnen Kategorien über das jeweilige Batteriemodul und/oder die Batterie gebildet. Diese Verteilung gibt also insbesondere an, wie viel Prozent an weiter für die Fahrzeugverwendung geeigneten, an für die Zweitnutzung anstehenden und an zu rezyklierenden Batteriezellen das jeweilige Batteriemodul bzw. die Batterie aufweist. Optional wird diese Verteilung wiederum mit einer Grenzverteilung verglichen und auf Basis dieses Vergleichs kategorisiert. Bspw. wird ein geringer Prozentsatz an für die Zweitnutzung anstehenden Batteriezellen für eine weitere Fahrzeugverwendung akzeptiert.

Weiter optional wird bei der Kategorisierung der Batteriemodule oder der gesamten Batterie zusätzlich auch eine Anzahl von im Betrieb aufgetretenen Warnmeldungen - insbesondere gewichtet - berücksichtigt. Bspw. kann die Gewichtung dabei mit zunehmenden von der Fahrzeugverwendung abweichenden, insbesondere "schlechteren" Kategorien im Batteriemodul oder der Batterie zunehmen, so dass mithin bei einer zunehmend zu einer Zweitverwendung tendierenden Verteilung der einzelnen "Zell-Kategorien" zunehmend weniger Warnmeldungen reichen, um die "Gesamtkategorie" der Batterie (oder des Batteriemoduls) auf eine "schlechtere" Kategorie, also bspw. von Fahrzeugverwendung auf Zweitverwendung, zu setzen.

In einer weiteren zweckmäßigen Verfahrensvariante werden der Batterie spezifisch Informationen über Herstellung und/oder Aufbau der wenigstens einen enthaltenen Batteriezelle, über Grenzen sicherheitsrelevanter und/oder lebensdauerrelevanter Betriebsgrößen und/oder über Maßnahmen zur Einleitung einer nachgelagerten Verwendung und/oder Verwertung zugeordnet. Bevorzugt werden diese Informationen nach der Herstellung, insbesondere herstellerseitig in der vorstehend beschriebenen Datenbank und/oder dem Batteriemanagementsystem hinterlegt. Insbesondere um diese Informationen auf einfache Weise beim Einbau der Batterie, optional auch bei deren Herstellung aus der oder mehreren Batteriezellen, abrufen zu können, wird die jeweilige Batteriezelle, ein aus mehreren Batteriezellen gebildetes Batteriemodul und/oder auch die Batterie selbst mit einem Barcode versehen, der diese Informationen und/oder einen Link auf die Datenbank zum Abruf dieser Informationen enthält.

Beispielsweise umfassen diese Informationen Angaben über die Zellenidentifikationsnummer und gegebenenfalls die Modul-, Batterie- sowie optional auch die Fahrzeugidentifikationsnummer, die für die Batteriezelle eingesetzte Zellchemie, eine Identifikationsnummer des Herstellers, eine vom Hersteller jeweils spezifizierte erlaubte (oder: "charakteristische") Zyklenzahl für eine Erstverwendung, Zweitverwendung und ein Erreichen des End-of-Life ("Verwendungsende") der jeweiligen Batteriezelle, eine vom Hersteller spezifizierte erlaubte Reichweite (Kilometerstand) für die Erstverwendung als Kraftfahrzeugbatterie, eine vom Hersteller spezifizierte erlaubte Betriebsdauer für die Erstverwendung, Zweitverwendung und das Erreichen des End-of-Life (entweder als Gesamtbetriebsdauer oder als getrennte Angaben für Lager-, Ruhe- und Nutzungszeiten), einen vom Hersteller spezifizierten erlaubten Ladungsdurchsatz bzw. eine Kapazität für die Erstverwendung, Zweitverwendung und das Erreichen des End-of-Life, zum anzuwendenden Recyclingverfahren (z.B. Recyclingschritte oder Recyclingmethoden), Hinweise zu gefährdenden Stoffen, einen vom Hersteller spezifizierten erlaubten Gesamtenergiedurchsatz für die Erstverwendung, Zweitverwendung und das Erreichen des End-of-Life, einen vom Hersteller spezifizierten erlaubten Gesamtleistungsdurchsatz für die Erstverwendung, Zweitverwendung und das Erreichen des End-of-Life, eine vom Hersteller spezifizierte erlaubte Betriebsdauer außerhalb des erlaubten Betriebsspannungsfensters und/oder außerhalb des erlaubten Betriebstemperaturfensters der Batteriezelle für die Erstverwendung, Zweitverwendung und das Erreichen des End-of-Life, zum anzuwendenden Entladeverfahren vor Start des Recyclings, ein Nominalgewicht der Batteriezelle und/oder ein Produktions- bzw. Formierungsdatum.

Die Batterie ist insbesondere zum Einsatz in einem Kraftfahrzeug (optional auch einem E-Bike, einem Roller, einem Wasserfahrzeug oder dergleichen) eingerichtet und vorgesehen. Die Batterie weist dabei - wie vorstehend bereits beschrieben - wenigstens eine Batteriezelle (vorzugsweise mehrere, zu Batteriemodulen zusammengefasste Batteriezellen) sowie ein Batteriemanagementsystem auf. Letzteres ist dazu eingerichtet, im Betrieb der Batterie eine Anzahl von sicherheitsrelevanten und lebensdauerrelevanten Betriebsgrößen für wenigstens eine Batteriezelle der Batterie zu erfassen und zur Durchführung des vorstehend beschriebenen Verfahrens einem Controller des Batteriemanagementsystems und/oder der vorstehend beschriebenen (insbesondere zu der Batterie oder dem Kraftfahrzeug) externen Datenbank zur Verfügung zu stellen.

In einer zweckmäßigen Ausführung ist das Batteriemanagementsystem, insbesondere dessen Controller dazu eingerichtet, einzelne Batteriezellen oder Batteriemodule, die gemäß der vorstehend beschriebenen Kategorisierung für die weitere Fahrzeugverwendung nicht mehr geeignet sind, aus dem Zellenstrang mehrerer Batteriezellen in einem Batteriemodul bzw. Modulstrang mehrerer Batteriemodule auszuschließen. Hierzu ist die Batterie vorteilhafterweise mit entsprechenden Schaltvorrichtungen ausgestattet, um einzelne Batteriezellen bzw. Batteriemodule aus dem entsprechenden Schaltungskreis heraustrennen zu können. In diesem Fall wird die Batterie also "rekonfiguriert".

In einer weiteren zweckmäßigen Ausführung ist das Batteriemanagementsystem, insbesondere für den Fall, dass die Informationen an die externe Datenbank übermittelt werden, dazu eingerichtet, die aktuellen Betriebsgrößen und daraus abgeleiteten Größen zur Aktualisierung an die Datenbank zu übermitteln. Insbesondere werden hierbei die aktuelle Kategorisierungsgröße, insbesondere deren Verteilung, Identifikationsmerkmale wie die Fahrzeugidentifikationsnummer bzw. Modulidentifikationsnummer, die aktuelle Zyklenzahl, der aktuelle Kilometerstand, der aktuelle Ladungsdurchsatz und/oder die aktuelle Kapazität, die aktuelle Betriebsdauer, aktuelle Zeiten außerhalb spezifizierter Betriebsfenster (z.B. Spannungsfenster, Temperaturfenster, Entladestromfenster), die Art und Anzahl von aufgetretenen Warnmeldungen und/oder Fahrzeugstatusmeldungen mit Sicherheitsbezug zur Batterie (z.B. Unfalldaten, Crashdaten, Propagationswarnungen, Überhitzungswarnungen, Tiefenentladungswarnungen, Überladungswarnungen, Überstromwarnungen, EMV-Warnungen etc.), der Zeitpunkt der nächsten Kategorisierung, der aktuelle Gesamtenergiedurchsatz, der aktuelle Gesamtleistungsdurchsatz und/oder die aktuelle Anzahl der Schnellladevorgänge übermittelt. Diese Größen werden insbesondere auch für die Kategorisierung seitens der Datenbank benötigt. Optional ist das Batteriemanagementsystem auch dazu eingerichtet, die charakteristischen, also insbesondere herstellerseitig für die jeweilige Batterie vorgegebenen charakteristischen Betriebsgrößen (d. h. deren charakteristischen Werte) von der Datenbank für die jeweilige Kategorisierung abzurufen.

Das erfindungsgemäße Batterieverwertungssystem umfasst die vorstehend beschriebene Datenbank, die die batteriespezifischen Informationen über Herstellung und/oder Aufbau der wenigstens einen, in der Batterie enthaltenen Batteriezelle, über Grenzen sicherheitsrelevanter und/oder lebensdauerrelevanter Betriebsgrößen und/oder über Maßnahmen zur Einleitung einer (der Haupt- oder Erstverwendung, insbesondere in dem Kraftfahrzeug) nachgelagerten Verwendung und/oder Verwertung der Batteriezelle enthält. Insbesondere werden diese Informationen wie vorstehend beschrieben der Datenbank zugeführt. Die Datenbank ist außerdem dazu eingerichtet, von dem Batteriemanagementsystem der Batterie eine Anzahl von sicherheitsrelevanten und lebensdauerrelevanten Betriebsgrößen für die wenigstens eine Batteriezelle der Batterie zu erhalten und das vorstehend beschriebene Verfahren insbesondere automatisch durchzuführen.

In einer zweckmäßigen Ausführung ist die Datenbank dazu eingerichtet ist, anhand der zugeführten Informationen Maßnahmen zur Einleitung einer nachgelagerten Verwendung und/oder Verwertung mehrerer Batterien hinsichtlich Aufwand und Kosten zu beurteilen und auf Basis dieser Beurteilung eine Auslastungsplanung für Einrichtungen zur Verwendung und/oder Verwertung zu erstellen. So wird beispielsweise ermittelt, wie viele verschiedene Batterien mit einer vergleichbaren Kategorieverteilung, chemischen Zusammensetzung und dergleichen in der Datenbank hinterlegt sind und zur weiteren Handhabung anstehen. Die Datenbank ist in diesem Fall vorteilhafterweise dazu eingerichtet, die kategorisierten Batterien insbesondere auch hinsichtlich ihrer Eigenschaften und weiteren Handhabung zu gruppieren, und die entsprechende Gruppeninformation - insbesondere zur besseren Auslastungsplanung in Recyclingbetrieben und/oder Werkstätten zum Umbau der Batterien für die Zweitverwendung - bspw. an den, den Gruppen örtlich nächstgelegenen oder zumindest zuständigen Recyclingbetrieb, der nächsten zuständigen Werkstatt oder dergleichen zu übermitteln.

Zusätzlich ist die Datenbank optional auch dazu eingerichtet, anhand der vorstehend beschriebenen Gruppierungen vorzugsweise anfallendes Recycling- und/oder Sondermüllvolumen, Verwertungs- bzw. Entsorgungskosten und dergleichen zu ermitteln.

Weiter zweckmäßig ist die Datenbank auch dazu eingerichtet, bspw. bei Ankunft eines eine zu rezyklierende Batterie aufweisenden Kraftfahrzeugs in einem Recyclingbetrieb einer - optional automatisierten - Recyclingmaschine Informationen über die für die spezifische Batterie erforderlichen Recyclingschritte zu übermitteln.

Das Kraftfahrzeug umfasst die vorstehend beschriebene Batterie.

Nachfolgend werden Ausführungsbeispiele der Erfindung anhand einer Zeichnung näher erläutert. Darin zeigen:

Fig. 1    in einer schematischen Ansicht eine Batterie mit einer Mehrzahl von aus mehreren Batteriezellen zusammengesetzten Batteriemodulen,

Fig. 2    in einer schematischen Ansicht ein Diagramm eines Informationsflusses von Daten zwischen einer Mehrzahl von Batterien und einer Datenbank,

Fig. 3    in einer schematischen Ansicht ein Diagramm eines Informationsflusses zwischen der Datenbank und einer Recyclingstelle für Batterien, und

Fig. 4    in einer schematischen Ansicht ein Kraftfahrzeug mit der Batterie.

Einander entsprechende Teile (und Größen) sind in allen Figuren stets mit gleichen Bezugszeichen versehen.

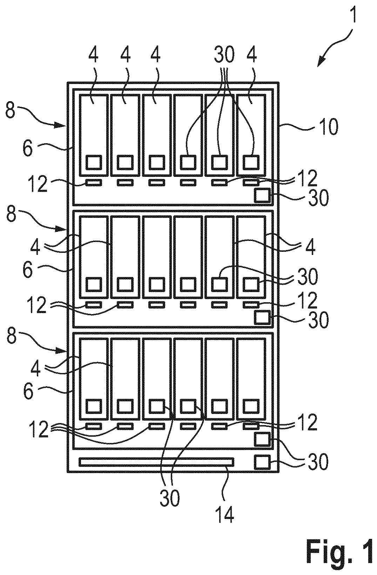

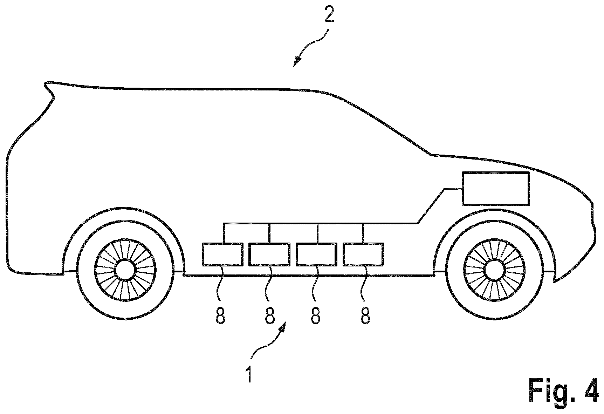

In Fig. 1 ist eine Traktionsbatterie, auch als Batteriepack, kurz als "Batterie 1" bezeichnet, eines Kraftfahrzeugs 2 (s. Fig. 4) dargestellt. Die Batterie 1 umfasst mehrere einzelne Batteriezellen, die als Sekundärzellen (d. h. als wieder aufladbare Batteriezellen) ausgebildet sind und kurz als "Zellen 4" bezeichnet werden. Die Zellen 4 sind zu mehreren in einem gemeinsamen Modulgehäuse 6 angeordnet und so zu einem Batteriemodul 8 zusammengefasst. Eine Verschaltung der einzelnen Zellen 4 untereinander ist nicht näher dargestellt. Die Batterie 1 umfasst ein Batteriegehäuse 10, in dem wiederum mehrere der Batteriemodule 8 angeordnet und ebenfalls nicht näher dargestellt miteinander verschaltet sind.

Zur Ermittlung aktueller Betriebsgrößen einer jeden Zelle 4 ist diesen jeweils eine Sensoreinheit 12 zugeordnet. Diese sind dazu eingerichtet, eine aktuelle Temperatur T der jeweiligen Zelle 4, den aktuellen Druck innerhalb der Zelle 4, sowie optional auch eine Gaskonzentration eines Zersetzungsgases von in der jeweiligen Zelle 4 enthaltenen Medien zu erfassen. Eine Abtastrate von etwa einem dreißigstel Hertz ist dabei ausreichend. Die Auflösung der einzelnen Sensorsignale sollte im Bereich von 1 Kelvin, 10 Kilopascal bzw. 1 ppm gelöstes Gas liegen.

Die Batterie 1 umfasst außerdem auch ein Batteriemanagementsystem 14, das einen Controller bildet, der unter anderem dazu eingerichtet ist, elektrische Betriebsgrößen der einzelnen Zellen 4, nämlich die aktuelle Spannung (vorzugsweise mit einer Auflösung von 1 Volt), die Lade- und Entladeströme, einen Gesamtladungsdurchsatz $Q_G$, eine aktuelle (Speicher-) Kapazität c sowie andere Betriebsgrößen wie die aufgelaufene Betriebsdauer der jeweiligen Zelle, eine Anzahl von durchgeführten Ladezyklen n, eine schnellgeladene Gesamtleistungsmenge, einen aktuellen Kilometerstand r des Kraftfahrzeugs 1 und dergleichen zu ermitteln.

Außerdem ist das Batteriemanagementsystem 14 dazu eingerichtet, selbsttätig ein Verfahren zu Kategorisierung der Batterie 1 hinsichtlich ihrer weiteren Handhabungseignung durchzuführen. Dazu ermittelt das Batteriemanagementsystem 14 anhand der Daten der jeweiligen Sensoreinheit 12 sowie der aktuellen Spannung über einen vorgegebenen Zeitraum in einer ersten Auswertungsstufe die Shannon-Entropie für jede Betriebsgröße und für jede Zelle 4.

Überschreitet eine der Shannon-Entropien einen vorgegebenen Schwellwert, gibt das Batteriemanagementsystem 14 für diese Zelle 4 die Kategorie "recycling grade" aus und bricht die weitere Auswertung für diese Zelle 4 ab.

Unterschreiten alle Shannon-Entropien den jeweiligen Schwellwert, geht das Batteriemanagementsystem 14 zu einer zweiten Auswertungsstufe über. In dieser zweiten Auswertungsstufe ermittelt das das Batteriemanagementsystem 14 für jede Zelle eine Weibullverteilung mittels der aufgelaufenen Betriebsdauer, der aufgelaufenen Zahl von Ladezyklen, der aktuellen und der ursprünglichen Kapazität, der aufgelaufenen schnellgeladenen Gesamtleistungsmenge und dem aufgelaufenen Kilometerstand. Die jeweiligen Parameter werden dabei ins Verhältnis zu ihrem (herstellerspezifisch zugeordneten) charakteristischen (d. h. bei bestimmungsgemäßer Verwendung zu erwartenden) Wert gesetzt.

Die Weibullverteilung einer jeden Zelle 4 gibt dabei eine Ausfallprognose, also eine Ausfallwahrscheinlichkeit (in Prozent) an. Anhand eines vorgegebenen Musters werden anschließend Kategorien, die sich auf Wertebereiche der Weibullverteilung beziehen, zugeordnet. Diese Kategorien geben an, ob die jeweilige Zelle 4 (nahezu) neuwertig ist, für eine weitere Verwendung im Kraftfahrzeug 2 geeignet ist ("automotive grade"), für eine Zweitverwendung (bspw. in der Industrie als Zwischenspeicher) zu empfehlen ist ("industrial grade") oder einer Materialverwertung zuzuführen ist ("recycling grade").

Anhand der Kategorien der einzelnen Zellen 4 erstellt das Batteriemanagementsystem 14 eine Kategorieverteilung der Batteriemodule 8 und der Batterie 1 anhand derer wiederum beurteilt wird, konkret anhand eines Schwellwertvergleichs, ob nur ein Batteriemodul 8 oder die gesamte Batterie 1 zu tauschen ist.

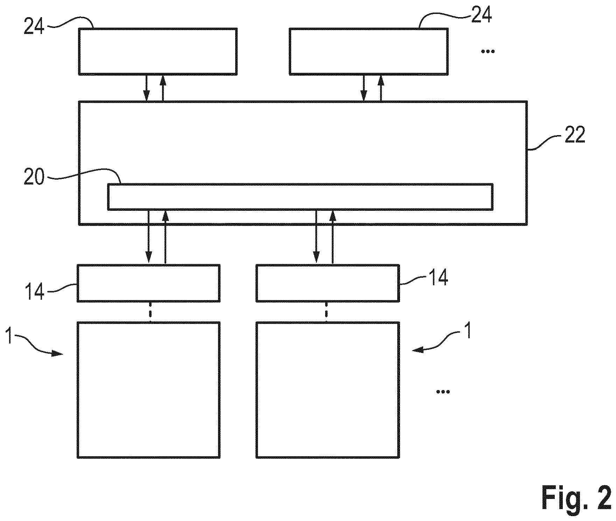

Für eine Redundanz oder Auslagerung der erfassten Betriebsgrößen sowie optional auch der Kategorisierung ist das Batteriemanagementsystem 14 dazu eingerichtet, die vorstehend beschriebenen Sensordaten und Betriebsgrößen sowie gegebenenfalls auch die Kategorien der Zellen 4 an eine Datenbank 20 (s. Fig. 2) zu übermitteln. Diese Datenbank 20 ist dabei auf einem Server 22 implementiert, der für mehrere Batteriemanagementsysteme 14 zugänglich ist und somit die Informationen mehrerer Batterien 1 bündeln kann. Mit diesem Server 22 stehen wiederum "clients 24" in kommunikativer Verbindung, die im Folgenden näher beschrieben werden.

Um die Informationen einer spezifischen Batterie 1 erstmalig mit einem herstellerseitig hinterlegten Eintrag in der Datenbank 20 verknüpfen oder die Informationen zur Speicherung auf einfache Weise an die Datenbank 20 übermitteln zu können, sind den jeweiligen Zellen 4, den Batteriemodulen 8 sowie der Batterie 1 jeweils Barcodes 30 zugeordnet, die einen Link zum entsprechenden Datenbankeintrag enthalten. Dieser Datenbankeintrag enthält dabei Informationen über die vorstehend genannten charakteristischen Werte der für die Kategorisierung erforderlichen Betriebsgrößen, Informationen über die verwendete Zellchemie, Herstellungsdatum und Herstellungsbetrieb und dergleichen. Außerdem enthält der Datenbankeintrag laufend aktualisiert die wie vorstehend beschriebenen Kategorien - seitens der Datenbank 20 ermittelt oder nach Ermittlung von dem Batteriemanagementsystem 14 an die Datenbank 20 übermittelt.

Die Datenbank 20 ist außerdem dazu eingerichtet, anhand der Kategorisierung mehrere Batterien 1 das Volumen der für eine Zweitverwendung, eine Materialverwertung und gegebenenfalls zur Deponierung oder sonstigen abschließenden Endverwertung nicht mehr recyclingfähiger Zellen 4 sowie der hierfür zu veranschlagenden Kosten abzuschätzen.

Der Server 22 mit der Datenbank 20 bildet insbesondere ein Batterieverwertungssystem, mittels dessen die Handhabungseignung (die aus der jeweiligen Kategorie hervorgeht) von Batterien 1 erfasst wird.

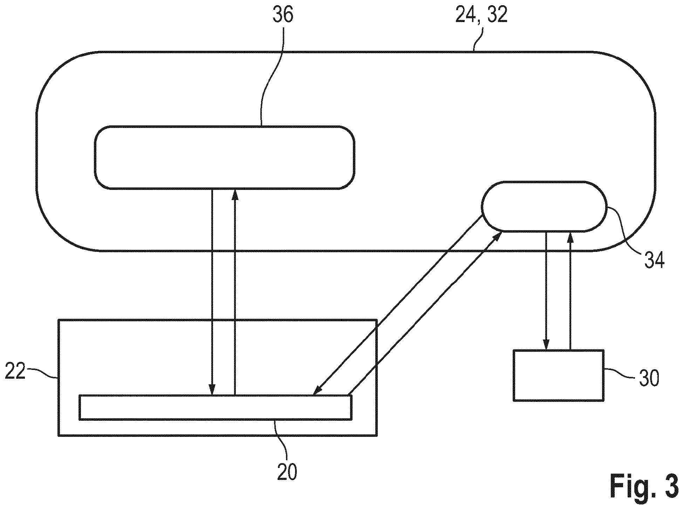

Wird für die Batterie 1 eines spezifischen Kraftfahrzeugs 1 nun ermittelt, dass die Batterie 1 dem Recycling zuzuführen ist, wird eine entsprechende Information an den Nutzer des Kraftfahrzeugs 1 ausgegeben (von der Datenbank 20 oder dem Batteriemanagementsystem 14 ausgelöst). Dieser kann dann beispielsweise zu einer Werkstatt fahren, um die Batterie 1 ausbauen und gegebenenfalls austauschen zu lassen. Wir die Batterie 1 einem Recyclingbetrieb 32, der einen der clients 24 darstellt, zugeführt (s. Fig. 3) können dort mittels eines Scanners 34 mittels des jeweiligen Barcodes 30 der Batterie 1 bzw. der Zellen 4 oder der Batteriemodule 8 Informationen über die Batterie 1 und den für die spezifische Batterie 1 erforderlichen Prozess der Verwertung von der Datenbank 20 abgerufen werden. Die Datenbank 20 übermittelt diese Informationen bspw. an eine Recyclingmaschine 36 des Recyclingbetriebs 32 oder zumindest an einen dortigen Server. Die Prozessabfolge für ein Recycling ist dabei häufig abhängig von der spezifischen Zellchemie und dem Aufbau der jeweiligen Zelle 4.

Da die Informationen über mehrere Batterien 1 zentral in der Datenbank 20 vorliegen, ist es auch möglich und vorteilhafterweise vorgesehen, dass mittels der Datenbank 20 eine Auslastungsplanung von Recyclingbetrieben 32 vorgenommen wird, indem bspw. unterschiedlichen Recyclingbetrieben 32 gleichartige Batterien 1 zur Verwertung zugeführt werden, so dass für eine Vielzahl von Batterien 1 gleiche Verwertungsprozessabfolgen erfolgen können, ohne Recyclingmaschinen 36 oder dergleichen immer wieder auf unterschiedliche Batterie-Typen umstellen zu müssen.

Der Gegenstand der Erfindung ist nicht auf die vorstehend beschriebenen Ausführungsbeispiele beschränkt. Vielmehr können weitere Ausführungsformen der Erfindung von dem Fachmann aus der vorstehenden Beschreibung abgeleitet werden. Insbesondere können die anhand der verschiedenen Ausführungsbeispiele beschriebenen Einzelmerkmale der Erfindung und deren Ausgestaltungsvarianten auch in anderer Weise miteinander kombiniert werden.

**Bezugszeichenliste**

| | |
|---|---|
| 1 | Batterie |
| 2 | Kraftfahrzeug |
| 4 | Zelle |
| 6 | Modulgehäuse |
| 8 | Batteriemodul |
| 10 | Gehäuse |
| 12 | Sensoreinheit |
| 14 | Batteriemanagementsystem |
| 20 | Datenbank |
| 22 | Server |
| 24 | dient |
| 30 | Barcode |
| 32 | Recyclingbetrieb |
| 34 | Scanner |
| 36 | Recyclingmaschine |

**Patentansprüche**

1. Verfahren zur Kategorisierung einer Batterie (1) hinsichtlich ihrer weiteren Handhabungseignung, wobei verfahrensgemäß

- im Betrieb der Batterie (1) eine Vielzahl von sicherheitsrelevanten und lebensdauerrelevanten Betriebsgrößen für wenigstens eine Batteriezelle (4) der Batterie (1) erfasst wird,
- mittels einer zweistufigen Auswertung wenigstens einer der Betriebsgrößen und/oder einer daraus abgeleiteten Rechengröße eine Kategorisierungsgröße bestimmt wird, **dadurch gekennzeichnet, dass**

+ in einer ersten Stufe für wenigstens eine sicherheitsrelevante Betriebsgröße eine Sicherheitsgröße abgeleitet und mit einem zugeordneten Schwellwert verglichen wird,
+ für den Fall, dass der Schwellwert oder einer der gegebenenfalls mehreren Schwellwerte unterschritten wird, in einer zweiten Stufe mittels einer Mehrzahl der lebensdauerrelevanten Betriebsgrößen eine Ausfallprognose erstellt wird, und
+ die Kategorisierungsgröße anhand der Ausfallprognose bestimmt wird,

wobei in der ersten Stufe für wenigstens eine Batteriezelle (4) der Batterie (1) eine Historiengröße, die charakteristisch für eine vorausliegende Betriebsbelastung ist, anhand der wenigstens einen für diese Batteriezelle (4) ermittelten sicherheitsrelevanten Betriebsgröße, bei der es sich um die Temperatur, die Spannung, einen Druck und/oder die Gaskonzentration eines Zersetzungsgases handelt, ermittelt wird,
wobei in der zweiten Stufe für wenigstens eine Batteriezelle (4) der Batterie (1) mittels der lebensdauerrelevanten Betriebsgrößen die Ausfallprognose anhand eines statistischen Modells ermittelt wird, in das die Betriebsgrößen Betriebsdauer der Batteriezelle (4), Zyklenzahl der Batteriezelle (4), Kapazität der Batteriezelle (4), schnellgeladene Gesamtleistungsmenge und/oder Kilometerstand eines die Batterie (1) umfassenden Kraftfahrzeugs (2) einbezogen werden,
wobei die Ausfallprognose der oder der jeweiligen Batteriezelle (4) anhand ihres Zahlenwerts einem Wertebereich der Kategorisierungsgröße zugeordnet wird, und
wobei der Kategorisierungsgröße wenigstens die Wertebereiche "Neuwertig", "Fahrzeugverwendung", "Zweitnutzung" und "Recycling" zugeordnet sowie dem Nutzer der Batterie entsprechende Empfehlungen oder Hinweise zur weiteren Handhabung angegeben werden.

2. Verfahren nach Anspruch 1,
wobei anhand von im Betrieb der Batterie (1) erfasster Sonderereignisse, die ein Recycling unmöglich machen, zumindest einer Batteriezelle (4) die Sonderkategorie "Sondermüll" zugeordnet wird.

3. Verfahren nach Anspruch 1 oder 2,
wobei die Batterie (1) mehrere in wenigstens ein Batteriemodul (8) zusammengefasste Batteriezellen (4) umfasst,
wobei die Kategorisierungsgröße für zumindest mehrere dieser Batteriezellen (4) ermittelt wird und wobei anhand der einzelnen Kategorisierungsgrößen eine Modul- und eine Batterie-Kategorisierungsgröße ermittelt wird.

4. Verfahren nach einem der Ansprüche 1 bis 3,
wobei der Batterie (1) spezifisch Informationen über Herstellung und/oder Aufbau der wenigstens einen, enthaltenen Batteriezelle (4), über Grenzen sicherheitsrelevanter und/oder lebensdauerrelevanter Betriebsgrößen und/oder über Maßnahmen zur Einleitung einer nachgelagerten Verwendung und/oder Verwertung zugeordnet werden.

5. Batterieverwertungssystem (20,22), umfassend eine Datenbank (20), die batteriespezifische Informationen über Herstellung und/oder Aufbau wenigstens einer, in einer Batterie (1) enthaltenen Batteriezelle (4), über Grenzen sicherheitsrelevanter und/oder lebensdauerrelevanter Betriebsgrößen und/oder über Maßnahmen zur Einleitung einer nachgelagerten Verwendung und/oder Verwertung der Batteriezelle (4) enthält, wobei die Datenbank (20) dazu eingerichtet ist, von einem Batteriemanagementsystem (14) der Batterie (1) eine Anzahl von sicherheitsrelevanten und lebensdauerrelevanten Betriebsgrößen für wenigstens eine Batteriezelle (4) der Batterie (1) zu erhalten und das Verfahren nach einem der Ansprüche 1 bis 4 durchzuführen.

6. Batterieverwertungssystem (20,22) nach Anspruch 5,
wobei die Datenbank (20) dazu eingerichtet ist, anhand der zugeführten Informationen Maßnahmen zur Einleitung einer nachgelagerten Verwendung und/oder Verwertung mehrerer Batterien (1) hinsichtlich Aufwand und Kosten zu beurteilen und auf Basis dieser Beurteilung eine Auslastungsplanung für Einrichtungen zur Verwendung und/oder Verwertung zu erstellen.

**Claims**

1. Method for categorizing a battery (1) with respect to its further handling suitability, wherein according to the method

- during operation of the battery (1), a plurality of safety-relevant and lifetime-relevant operating variables are registered for at least one battery cell (4) of the battery (1),
- a categorization variable is determined by means of a two-step evaluation of at least one of the operating variables and/or of a computed variable derived therefrom,
**characterized in that**

+ in a first step, for at least one safety-relevant operating variable, a safety variable is derived and compared with an assigned threshold value,
+ if the threshold value or one of the possibly multiple threshold values is undershot, in a second step a failure prognosis is prepared by means of a plurality of the lifetime-relevant operating variables, and
+ the categorization variable is determined on the basis of the failure prognosis,

wherein in the first step, for at least one battery cell (4) of the battery (1), a history variable, which is characteristic of a preceding operating load, is ascertained on the basis of the at least one safety-relevant operating variable which has been ascertained for this battery cell (4) and is the temperature, the voltage, a pressure, and/or the gas concentration of a decomposition gas,
wherein in the second step, for at least one battery cell (4) of the battery (1), the failure prognosis is ascertained by means of the lifetime-relevant operating variables on the basis of a statistical model, in which the operating variables of the operating duration of the battery cell (4), number of cycles of the battery cell (4), capacity of the battery cell (4), quick-charged total amount of power, and/or mileage of a motor vehicle (2) comprising the battery (1) are incorporated, wherein the failure prognosis of the or the respective battery cell (4) is assigned on the basis of its numerical value to a value range of the categorization variable, and
wherein at least the value ranges "like new", "vehicle use", "second utilization", and "recycling" are assigned to the categorization variable and appropriate recommendations or suggestions for further handling are indicated to the user of the battery.

2. Method according to Claim 1,
wherein at least one battery cell (4) is assigned the special category "hazardous waste" on the basis of special events which are registered during operation of the battery (1) and make recycling impossible.

3. Method according to Claim 1 or 2,
wherein the battery (1) comprises multiple battery cells (4) assembled into at least one battery module (8), wherein the categorization variable is ascertained for at least multiple of these battery cells (4) and wherein a module categorization variable and a battery categorization variable are ascertained on the basis of the individual categorization variables.

4. Method according to any one of Claims 1 to 3,
wherein the battery (1) is specifically assigned information about the production and/or structure of the at least one included battery cell (4), about limits of safety-relevant and/or lifetime-relevant operating variables, and/or about measures for initiating downstream use and/or utilization.

5. Battery utilization system (20, 22) comprising a database (20) which contains battery-specific information about the production and/or structure of at least one battery cell (4) contained in a battery (1), about limits of safety-relevant and/or lifetime-relevant operating variables and/or about measures for initiating downstream use and/or utilization of the battery cell (4), wherein the database (20) is configured to receive a number of safety-relevant and lifetime-relevant operating variables for at least one battery cell (4) of the battery (1) from a battery management system (14) of the battery (1) and to carry out the method according to any one of Claims 1 to 4.

6. Battery utilization system (20, 22) according to Claim 5,
wherein the database (20) is configured, on the basis of the supplied information, to assess measures for initiating downstream use and/or utilization of multiple batteries (1) with respect to effort and costs and to prepare a capacity plan for units for use and/or utilization on the basis of this assessment.

**Revendications**

1. Procédé de catégorisation d'une batterie (1) en ce qui concerne son aptitude à la manipulation ultérieure, procédé selon lequel

   - en fonctionnement de la batterie (1), une pluralité de grandeurs opérationnelles relatives à la durée de vie étant acquises pour au moins un élément de batterie (4) de la batterie (1),
   - une grandeur de catégorisation étant déterminée au moyen d'une interprétation en deux étapes d'au moins l'une des grandeurs opérationnelles et/ou d'une grandeur de calcul qui en est dérivée,

   **caractérisé en ce que**

   + dans une première étape, une grandeur de sécurité est dérivée pour au moins une grandeur opérationnelle relative à la sécurité et comparée à une valeur de seuil associée,
   + dans le cas où la valeur de seuil ou l'une des éventuelles plusieurs valeurs de seuil est franchie vers le bas, une prévision de panne est établie dans une deuxième étape au moyen d'une pluralité de grandeurs opérationnelles relatives à la durée de vie, et
   + la grandeur de catégorisation est déterminée au moyen de la prévision de panne,
   dans la première étape, pour au moins un élément de batterie (4) de la batterie (1), une grandeur historique étant identifiée, laquelle est caractéristique pour une charge de fonctionnement antérieure, à l'aide de l'au moins une grandeur opérationnelle relative à la sécurité identifiée pour cet élément de batterie (4), celle-ci étant la température, la tension, une pression et/ou la concentration de gaz d'un gaz de décomposition,
   dans la deuxième étape, pour au moins un élément de batterie (4) de la batterie (1), la prévision de panne est identifiée au moyen des grandeurs opérationnelles relatives à la durée de vie à l'aide d'un modèle statistique dans lequel sont impliquées les grandeurs opérationnelles durée de fonctionnement de l'élément de batterie (4), nombre de cycles de l'élément de batterie (4), capacité de l'élément de batterie (4), quantité de puissance totale de charge rapide et/ou kilométrage d'un véhicule motorisé (2) comprenant la batterie (1),
   la prévision de panne de l'élément de batterie (4) ou de l'élément de batterie respectif étant associée, à l'aide de sa valeur numérique, à une plage de valeurs de la grandeur de catégorisation, et
   au moins les plages de valeurs « à l'état neuf, « utilisation du véhicule », « deuxième usage » et « recyclage » étant associées à la grandeur de catégorisation et des recommandations ou des consignes correspondantes à propos de la manipulation ultérieure étant indiquées à l'utilisateur de la batterie.

2. Procédé selon la revendication 1, la catégorie spéciale « déchets spéciaux » étant associée à au moins un élément de batterie (4) à l'aide d'événements spéciaux détectés en fonctionnement de la batterie (1), lesquels rendent un recyclage impossible.

3. Procédé selon la revendication 1 ou 2, la batterie (1) comportant plusieurs éléments de batterie (4) regroupés dans au moins un module de batterie (8), la grandeur de catégorisation étant identifiée pour au moins plusieurs de ces et une grandeur de catégorisation de module et de batterie étant identifiée à l'aide des grandeurs de catégorisation individuelles.

4. Procédé selon l'une des revendications 1 à 3, des informations spécifiques à propos de la fabrication et/ou de la structure de l'au moins un élément de batterie (4) contenu, à propos des limites des grandeurs opérationnelles relatives à la sécurité et/ou relatives à la durée de vie et/ou à propos de mesures destinées à initier une utilisation en aval et/ou une valorisation étant associées à la batterie (1).

5. Système de valorisation de batterie (20, 22), comprenant une base de données (20), qui contient des informations spécifiques à la batterie à propos de la fabrication et/ou de la structure d'au moins un élément de batterie (4) contenu dans la batterie (1), à propos des limites des grandeurs opérationnelles relatives à la sécurité et/ou relatives à la durée de vie et/ou à propos de mesures destinées à initier une utilisation en aval et/ou une valorisation de l'élément de batterie (4), la base de données (20) étant conçue pour obtenir, de la part d'un système de gestion de batterie (14) de la batterie (1), un certain nombre de grandeurs opérationnelles relatives à la sécurité et relatives à la durée de vie pour au moins un élément de batterie (4) contenu dans la batterie (1) et pour mettre en œuvre le procédé selon l'une des revendications 1 à 4.

6. Système de valorisation de batterie (20, 22) selon la revendication 5, la base de données (20) étant conçue pour, à l'aide des informations acheminées, évaluer des mesures destinées à initier une utilisation en aval et/ou une valorisation de plusieurs batteries (1) en ce qui concerne l'effort et le coût et, sur la base de cette évaluation, établir une planification de charge de travail pour des dispositifs servant à l'utilisation et/ou à la valorisation.

Fig. 1

Fig. 2

36      24, 32

22

20

30

34

**Fig. 3**

Fig. 4

**IN DER BESCHREIBUNG AUFGEFÜHRTE DOKUMENTE**

**In der Beschreibung aufgeführte Patentdokumente**

- CN 106324516 A
- DE 102015110961 A1
- DE 102016220860 A1
- US 20160018345 A1
- DE 102016211898 A1